(19) Europäisches Patentamt
European Patent Office
Office européen des brevets

(11) Publication number: 0 302 828 A2

(12) # EUROPEAN PATENT APPLICATION

(21) Application number: 88810519.4

(22) Date of filing: 27.07.88

(51) Int. Cl.[4]: G 03 F 7/10

(30) Priority: 05.08.87 GB 8718525

(43) Date of publication of application: 08.02.89 Bulletin 89/06

(84) Designated Contracting States: BE CH DE FR GB IT LI NL

(71) Applicant: CIBA-GEIGY AG
Klybeckstrasse 141
CH-4002 Basel (CH)

(72) Inventor: Blyth, Jeffrey
7 Bath Street
Brighton BN1 3TB (GB)

(54) **Photopolymerizable composition.**

(57) There is described a photopolymerizable composition which comprises a water-soluble non-volatile ethylenically unsaturated monomer, a photopolymerization initiator which comprises a) at least one tertiary amine group or at least one active methylene or methine group, b) a dye sensitizer and c) a salt containing the hypophophite anion $H_2 PO_2^-$.

A particularly suitable hypophosphite salt is sodium hypophosphite. A suitable amount of hydrophosphite salt to be present is from 0.1 to 5.0 % of the weight of the photoinitiator present in the composition.

The presence of the hypophosphite salt in the composition has been found to reduce the required exposure time considerably or to reduce the required threshold exposure required to obtain a holographic image.

EP 0 302 828 A2

**Description**

**Photopolymerizable composition**

This invention relates to novel photopolymerizable compositions and in particular to photopolymerizable compositions which are of use in the production of volume holograms.

A large number of photopolymerizable systems are known wherein under the action of light a polymer is formed from a monomer or a mixture of monomers. Photopolymerizable materials have been used to provide raised images and in the production of photoresists.

A review of photopolymerizable processes is set forth in Chapter X of "Imaging Systems" Jacobson and Jacobson, John Wiley and Sons, N Y. pages 181 - 222 (1976). Dye-sensitized photopolymerization is also discussed in this chapter.

In the well-known book "Light-sensitive Systems" by J. Kosar, John Wiley and Sons, in Chapter 5 (1965), there are discussed various photopolymerization processes. On pages 184 - 187 of this book there is a section on photo-reducible dyes. It states on these pages that it has been well known for many years that certain dyes will in the presence of electron donors (i.e. reducing agents) undergo reduction to their leuco form when illuminated by light. The article states that the reduced dye then reacts with ambient oxygen to produce free radicals which can initiate polymerization of a polymerizable monomer. However it is now thought that no reaction with oxygen is required to produce free radicals.

A large number of photopolymerizable compositions are known but in general they are rather slow. We have now found an additive which when present in a photopolymerizable composition reduces greatly the exposure time required.

Therefore according to the present invention there is provided a photopolymerizable composition which comprises a water-soluble non-volatile ethylenically unsaturated monomer and a photopolymerization initiator which comprises (a) a compound having at least one tertiary amine group or at least one active methylene or methine group, (b) a dye sensitizer and (c) a salt containing the hypophosphite anion $H_2 PO_2^-$.

A particularly suitable hypophosphite salt is sodium hypophosphite. A suitable amount of hypophosphite to be present is from 0.1 to 5 % of the weight of the photoinitiator (a) + (b) + (c) present in the composition.

The presence of the hypophosphite salt in the composition has been found to reduce the required exposure time considerably or to reduce the required threshold exposure required to obtain a holographic image.

The preferred ethylenically unsaturated monomers for use in the present invention are the metal salts of acrylic or methacrylic acids. The preferred salts are lithium, sodium, potassium, barium, lead, zinc or magnesium acrylate. The most preferred salts are lithium or zinc acrylate.

A mixture of the metal acrylates may be used or mixtures of a metal acrylate and another ethylenically unsaturated monomer such as acrylamide, methacrylamide, N-hydroxymethylacrylamide, methylenebisacrylamide. Also esters of acrylic and methacrylic acids having a low volatility may also be used, for example pentaerythritol tetraacrylate, trimethylolpropane trimethacrylate and polybutanediol diacrylate.

The photoinitiator used in the compositions of the present invention may contain as component (a) any compound which comprises at least one tertiary amine group which has been used in the past in photopolymerizable compositions such as triethanolamine. Particular suitable components (a) are hydroxyalkylamine derivatives of the general formula

(1) 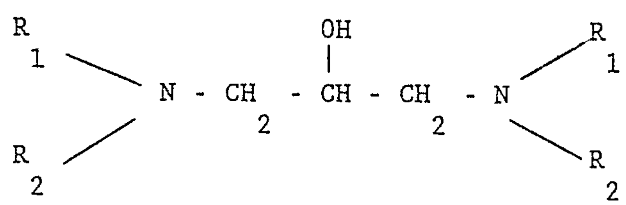

where $R_1$ is hydrogen, an alkyl group having 1 to 4 carbon atoms or a group of the formula

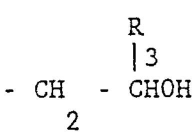

where $R_3$ is hydrogen or an alkyl group having 1 to 4 carbon atoms and $R_2$ is also a group of formula (2).

Another very useful component (a) is a polymer of the general formula

(3) 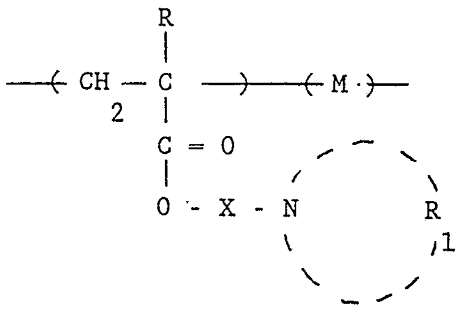

where R is a hydrogen atom or a lower alkyl group having 1 to 4 carbon atoms, X is an alkylene chain having 2 to 4 carbon atoms in the chain, $R_1$ represents the atoms necessary to complete an optionally substituted 5 or 6 membered saturated nitrogen containing ring and which may contain a further heteroatom and M represents the residue of an ethylenically unsaturated comonomer which may be present in the polymer up to 20% by weight of the polymer.

Another class of useful components (a) are compounds having an active methylene or methine group such as the β-dicarbonyl compounds, the β-ketonitrile compounds and the β-ketoimine compounds described in US 3,488,269. A particularly useful β-dicarbonyl compound is 5,5-dimethyl 1,3-cyclohexanedione or dimedone and this is the preferred compound (a).

The dye sensitizer, which is component (b) of the polymerisation initiator and which is capable of initiating free radical polymerisation on exposure to light may be any one of the dyes mentioned in the references hereinbefore set forth. Suitable dyes include riboflavin, Rose Bengal, erythrosin and eosin. However the preferred dye is Methylene Blue.

The photopolymerizable composition of the present invention may be used in the production of photoresists or in the production of raised images but it has particular utility in the production of holograms.

Therefore according to a second aspect of the present invention there is provided an assembly for the preparation of a hologram which comprises a transparent supporting base on which is coated a photopolymerizable composition as just defined which has been dispersed in a hydrophilic water swellable binder.

A particularly useful binder is gelatin. Other useful binders which may be used alone or preferably in admixture with gelatin are those generally used as binders for silver halide photographic materials and include albumin, casein, cellulose derivatives such as hydroxyethyl cellulose and carboxymethyl cellulose, polyvinyl alcohol, polyvinyl pyrrolidone and polyacrylamide. Preferably, at least 25% by weight of gelatin is present in such binders.

Other components which may be optionally present in the assembly for the preparation of a hologram are for example surfactants such as alkyl sulphates, alkylaryl sulphonates, polyalkoxylated phenols and other surfactants well known in the literature. Inhibitors may be present to ensure dark stability of the coated compositions, examples being hydroquinone, p-methoxyphenol and t-butyl catechol.

Humectants may be present in order to allow better control over the moisture content of the coated layer during the necessary pre-exposure moisture activation step and these may include ethylene glycol, glycerol, trimethylolpropane and other polyhydroxy compounds as well as other compounds known in the art.

The photopolymerizable compositions of the present invention may be dispersed in an aqueous binder solution and then coated by the conventional techniques well known to the photographic industry by doctor bar, slot, cascade, curtain and dip, and the coated layers air dried.

The coated assemblies may be stored essentially unchanged for several months under low moisture, low temperature conditions. Before exposure the coatings are activated by bringing them into a controlled humidity environment, whereupon sufficient moisture is absorbed to enable the photopolymerization to occur.

Exposure may be to white light or light of selected wavelengths, and the compositions of the present invention are especially suitable for exposure to lasers. The exposed assemblies may be processed by the well known sequence of swelling in a hydrophilic bath (e.g. pure water) followed by shrinking and dehydration in a water-miscible solvent.

The hydrophilic processing bath may contain, if desired, additional components, for example compounds which bring about an increase in the wavelength of the processed hologram, and compounds which lead to improved image stability. The dehydrated, exposed coatings may then be dried with warm air and laminated if required, to produce moisture stable holographic images.

The following Example will serve to illustrate the invention.

EXAMPLE

The following two compositions were prepared :

1)
28 ml gelatin solution (20 % by weight of solution)
10 ml zinc acrylate solution (20 % by weight of solution)
2 ml methylene blue solution ( 4 % by weight of solution)
6 ml dimedone solution (15 % by weight of solution)
0.5 ml surfactant

2)
28 ml gelatin solution (20 % by weight of solution)
10 ml zinc acrylate solution (20 % by weight of solution)
2 ml methylene blue solution (4 % by weight of solution)
6 ml dimedone solution (15 % by weight of solution)
0.5 ml surfactant
0.4 ml sodium hypophosphite (40 % by weight of solution)

This last composition is a composition according to the present invention.

All the coating compositions were coated under green safe-light conditions at 50° C on to glass plates. The coating were allowed to gel and then were warm air dried to give a coating thickness of 10 µm.

The coatings were stored for 24 hours at a relative humidity of 60% and holographically exposed using a Denisyuk exposure method and a 5 mW helium/neon laser with a standard metallic test object for 1 minute.

The energy received by each coated plate during the holographic exposure was 42 mJ/cm$^2$.

After the holographic exposure both coated plates were processed as follows :-

i) 1 minute soak in a water bath at 16° C with mild agitation,

ii) 20 seconds in an aqueous isopropyl alcohol bath at 16° C with strong agitation (water content 20 % volume) and

iii) 5 minutes in a dry isopropyl alcohol bath at 20° C (water content below 2 % by volume)

Each plate was then warm air dried and the resultant hologram was examined.

On the plate which had been coated with composition 1) there was found on reconstruction a barely discernable hologram which was of no use for display purposes.

On the plate which had been coated with composition 2) there was found on reconstruction a bright hologram which was of use for display purposes.

This shows that the exposure threshold value for this composition had been lessened by the use of the hypophosphite.

## Claims

1. A photopolymerizable composition which comprises a water-soluble non-volatile ethylenically unsaturated monomer and a photopolymerization initiator which comprises (a) a compound having at least one tertiary amine group or at least one active methylene or methine group (b) a dye sensitizer and (c) a salt containing the hypophoshpite anion $H_2 PO_2^-$.

2. A composition according to claim 1 wherein the hypophosphite salt (c) is sodium hypophosphite.

3. A composition according to claim 1 wherein the amount of hypophosphite salt present is from 0.1 to 5 % by weight of the photopolymerization initiator present in the composition.

4. A composition according to claim 1 wherein the monomer is either lithium or zinc acrylate.

5. A composition according to claim 1 wherein the dye sensitizer (b) is methylene blue.

6. A composition according to claim 1 wherein the compound (a) is dimedone.

7. An assembly for the preparation of a hologram which comprises a transparent supporting base on which is coated a photopolymerizable composition claimed in claim 1, dispersed in a hydrophilic water swellable binder.

8. An assembly according to claim 7 wherein the water-swellable binder is gelatin.

9. A hologram which has been prepared from the assembly claimed in claim 7.